# EUROPÄISCHE PATENTSCHRIFT

(11) **EP 1 571 234 B1**
(45) Veröffentlichungstag und Bekanntmachung des Hinweises auf die Patenterteilung: **18.06.2008**
(21) Anmeldenummer: 04024454.3
(22) Anmeldetag: 14.10.2004
(51) Int. Cl.: C23C 14/56

(54) **Verfahren für den Betrieb einer Inline-Beschichtungsanlage**
Method for using an in line coating apparatus
Méthode pour l'usage d'un dispositif de revêtement en continu

(30) Priorität: 21.02.2004 DE 102004008598
(43) Veröffentlichungstag der Anmeldung: 07.09.2005
(73) Patentinhaber: Applied Materials GmbH & Co. KG, 63755 Alzenau (DE)
(72) Erfinder: Richert, Holger, 63486 Bruchköbel (DE); Weimann, Manfred, 63755 Alzenau (DE)
(74) Vertreter: Schickedanz, Willi

(56) Entgegenhaltungen:
- DE-A1- 3 016 069
- US-A1- 2002 078 892

## Beschreibung

Die Erfindung betrifft Verfahren nach dem Oberbegriff des Patentanspruchs 1.

Um Substrate zu beschichten, werden Sputteranlagen eingesetzt, in denen unter Vakuumbedingungen von so genannten Targets Partikel zerstäubt werden, die sich dann auf dem Substrat niederschlagen.

Werden dabei die Substrate kontinuierlich in die Sputteranlage eingeschleust und aus dieser wieder ausgeschleust, spricht man von einer Inline-Beschichtungsanlage oder auch von einer "pass-through"-Beschichtungsanlage.

Eine solche Anlage besteht entweder aus einer linearen Anordnung von relativ kleinen, aber miteinander verbundenen Einzelkammern oder aus einer oder zwei großen Kammern mit Vakuum-Übergangs-Verriegelungen an jedem Ende der Linie. Die Prozesskammern sind entweder entlang einer großen Kammer oder in jeder individuellen Kammer vorgesehen.

Es ist bereits ein Inline-Sputter-System bekannt, das drei konzentrische Zylinder aufweist, wobei der innere und der äußere Zylinder eine ringförmige Kammer mit zylindrischen Wänden bilden (US 5 753 092). Ein mittlerer Zylinder, der zwischen dem inneren und dem äußeren Zylinder angeordnet ist, weist Substrate tragende Öffnungen auf und dient als zylindrischer Träger, der im Wesentlichen die ringförmige Durchgangskammer ausfüllt und der schrittweise drehbar ist.

Weiterhin ist eine Vorrichtung zur defektfreien Beschichtung von Substraten mit einer Beschichtungsstrecke bekannt, die eine Vakuumbeschichtungssektion und eine Eingangs- und Ausgangsschleuse aufweist (DE 200 22 564 U1). Hierbei ist außerdem ein Carrier vorgesehen, der einen Carriereinsatz zur Aufnahme der Substrate enthält. Die Carrierbahn ist als geschlossene Bahn ausgeführt.

Bekannt ist auch eine Beschichtungsanlage mit mehreren Vakuumbeschichtungskammem (US 2002/0078892 A1). Hierbei ist ebenfalls eine Durchtrittskammer in der Vakuumkammer angeordnet, wobei die Vakuumbeschichtungskammem hermetisch mit der Durchtrittskammer verbunden sind. Ein Transportsystem transportiert ein Substrat über die Durchtrittskammer in die Vakuumbeschichtungskammem, wobei das Transportsystem einen Substrathalter aufweist, mit welchem das Substrat aufrecht gehalten wird, sodass die Oberfläche einer Platte einen Winkel in Bezug auf die Horizontale von 45° bis 90° aufweist.

Des Weiteren ist eine Vorrichtung zum Aufsprühen von Materialien auf Substrate bekannt, mit einer Arbeitskammer, die einen Beschichtungskammerabschnitt und einen Trennkammernabschnitt umfasst (DE 30 16 069 A1). An diesen Trennkammerabschnitt grenzt eine Zutritts- bzw. Austrittskammer an. Je ein Drucktor befindet sich zwischen den Kammerabschnitten, dem Trennkammerabschnitt und der Zutritts- bzw. Ausleitkammer sowie der Umgebungsluft. Dabei sind zum Evakuieren der Zutritts- bzw. Ausleitkammer Grobvakuum-Pumpeinrichtungen vorgesehen.

Um bei einer Inline-Beschichtungsanlage Platz zu sparen, ist es bekannt, die Zahl der erforderlichen Träger zu reduzieren, indem eine Rückkammer vorgesehen ist (JP 2002309372 A). Die Träger fahren hierbei mit den Substraten in eine erste Richtung, drehen sich dann um 180 Grad und fahren anschließend in eine zweite Richtung.

Die Kammern der bekannten Vorrichtungen sind auf bestimmte Größen der Substrate zugeschnitten. Sollen Substrate mit Übergrößen bearbeitet werden, müssen andere Vorrichtungen mit größeren Kammern verwendet werden.

Der Erfindung liegt deshalb die Aufgabe zugrunde, mit nur einer Beschichtungsanlage sowohl normale Substrate als auch Substrate mit Übergröße beschichten zu können.

Diese Aufgabe wird durch die Merkmale des Patentanspruchs 1 gelöst.

Die Erfindung betrifft somit ein Verfahren für den Betrieb einer Inline-Beschichtungsanordnung, die aus 2 n + 1 Kammern besteht, wobei n eine ganze Zahl, und zwar größer oder gleich 2, ist. Indem wenigstens zwischen zweimal zwei Kammern dieser Anlage jeweils ein Tor geöffnet und geschlossen werden kann, ist es möglich, mit der gleichen Anlage auch Substrate mit Übergröße zu beschichten. Das Öffnen und Schließen der Tore ist dabei mit einer Änderung der Druckverläufe im Vergleich zu einem Standardbetrieb verbunden.

Der mit der Erfindung erzielte Vorteil besteht insbesondere darin, dass vorhandene Anlagen besser ausgenutzt werden können.

Ausführungsbeispiele der Erfindung sind in den Zeichnungen dargestellt und werden im Folgenden näher beschrieben. Es zeigen:
Fig. 1 eine 3-Kammer-Beschichtungsanlage, die nicht Gegenstand der Erfindung ist, in einer Seitenansicht; einer Seitenansicht;
Fig. 2 eine 5-Kammer-Beschichtungsanlage in einer Seitenansicht;
Fig. 3 eine 3-Kammer-Beschichtungsanlage in einer Draufsicht;
Fig. 4 eine 5-Kammer-Beschichtungsanlage in einer Draufsicht;
Fig. 5 einen Teil einer 5-Kammer-Beschichtungsanlage in einer geschnittenen Seitenansicht.

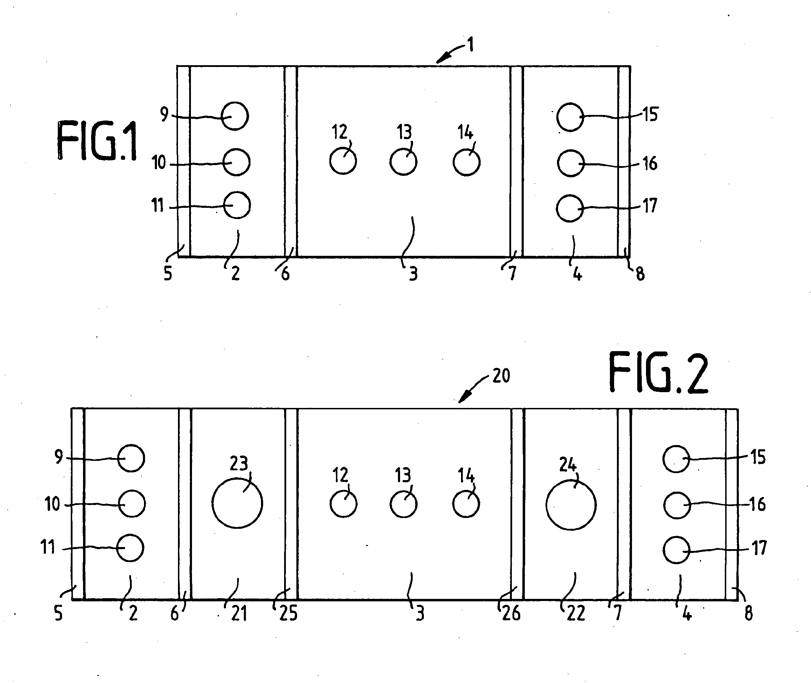

In der Fig. 1 ist eine Beschichtungsanlage 1 in einer Seitenansicht gezeigt. Diese Beschichtungsanlage 1 weist drei Kammern auf: eine Einschleuskammer 2, eine Prozesskammer 3 und eine Ausschleuskammer 4. Zwischen den verschiedenen Kammern 2, 3, 4 und am Eingang der Kammern 2, 4 befinden sich insgesamt vier Tore, die geöffnet und vakuumdicht geschlossen werden können. In der Fig. 1 sind die Tore selbst nicht zu erkennen, sondern Ansätze 5 bis 8, welche die Positionen der Tore andeuten. Die zu beschichtenden Substrate, beispielsweise flaches Architekturglas, Metallplatten, Si-Wafer, Kunststoffplatten und dergleichen, werden bei der Einschleuskammer 2 eingeführt, dann in der Prozesskammer 3 beschichtet, um anschließend über die Ausschleuskammer 4 herausgeführt zu werden. Die Substrate können dabei mit oder ohne Träger durch die Kammern 2, 3, 4 bewegt werden. Eine Transportanlage für den Transport der Substrate befindet sich jedoch in jedem Fall in den Kammern 2, 3, 4.

Mit 9 bis 17 sind Pumpen bezeichnet, welche die Kammern 2, 3, 4 bis zu einem vorgegebenen Druckwert evakuieren. Die Pumpen sind hier an den Seitenwänden der Kammern angeordnet. Sie können jedoch auch auf den Decken der Kammern angeordnet sein.

Die Größe der Kammern 2 bis 4 wird durch das maximale Substratmaß festgelegt, das beispielsweise bei Architekturglas 2,54 m x 3,66 m oder 3,21 m x 6,00 m beträgt. Die Anzahl der Kammern wird durch die minimal gewünschte Zykluszeit bestimmt. Unter Zykluszeit wird dabei diejenige Zeit verstanden, die von der Eingabe eines ersten Substrats in die Kammer 2 bis zur Eingabe eines zweiten Substrats in dieselbe Kammer 2 vergeht. Für eine Zykluszeit bis ca. 90 Sekunden wird in der Regel ein so genanntes Drei-Kammern-Prinzip verwendet, wie es in der Fig. 1 dargestellt ist.

Hierbei wird ein Substrat bei geöffnetem Tor am Ansatz 5 in die Kammer 2 eingeführt, deren Innendruck bei dann wieder geschlossenem Tor am Ansatz 5 und geschlossenem Tor am Ansatz 6 durch die Pumpen 9 bis 11 verringert wird, beispielsweise auf 0,05 mbar. Die Bewegung des Substrats, das sich in der Regel auf einem Träger oder Carrier befinden kann, ist hierbei diskontinuierlich, weil auch das Tor am Ansatz 6 zunächst geschlossen ist und das Substrat von diesem Tor zum Stillstand gebracht werden muss.

Hat der Druck in der Einschleuskammer 2 den vorgegebenen Wert von etwa 0,05 mbar erreicht, wird das Tor am Ansatz 6 geöffnet und das Substrat kontinuierlich durch die Kammer 3 bewegt, in der Vakuum herrscht. In dieser Kammer 3 wird dann die Beschichtung durchgeführt. Nach der Beschichtung wird das Substrat über die Ausschleuskammer 4 nach draußen bewegt.

Bei einer 3-Kammer-Beschichtungsanlage sind die Zykluszeiten relativ groß, weil das Substrat relativ lang in der Einschleuskammer 2 verbleiben muss, damit in der Kammer der vorgegebene niedrige Druck erreicht wird.

Kürzere Zykluszeiten erreicht man mit einer 5-Kammer-Beschichtungsanlage 20, wie sie in der Fig. 2 dargestellt ist. Diese 5-Kammer-Beschichtungsanlage 20 weist gegenüber der 3-Kammer-Beschichtungsanlage 1 noch zwei zusätzliche Pufferkammern 21, 22 bei den Ansätzen 25, 26 mit entsprechenden Pumpen 23, 24 auf. Da die Substrate bei einer 5-Kammer-Beschichtungsanlage 20 schneller durch die Kammern 2, 21, 3, 22, 4 bewegt werden können, sind die Zykluszeiten kürzer. Diese schnellere Bewegung ist dadurch bedingt, dass die Evakuierung der Kammern 2, 21 bzw. 22, 4 anders erfolgt als die der Kammern 2, 4 bei dem 3-Kammer-System der Fig. 1

Die Substrate werden bei der 5-Kammer-Beschichtungsanlage 20 im Anlagentakt in die Einschleuskammer 2 diskontinuierlich eingeschleust, wobei der Druck in der Einschleuskammer 2 bis auf ca. 15 mbar verringert wird, also nicht auf 0,05 mbar wie bei der 3-Kammeranlage. Im nächsten Takt werden die Substrate in die Pufferkammer 21 umgeschleust, wobei der Druck in der Pufferkammer 21 nahe dem Druck in der Prozesskammer 3 gebracht wird. Nachdem die Substrate kontinuierlich durch die Prozesskammer 3 bewegt wurden, werden sie über die Pufferkammer 22 und die Ausschleuskammer 4 nach draußen gebracht, wo Atmosphärendruck herrscht.

Die Zykluszeit reduziert sich bei der 5-Kammer-Beschichtungsanlage 20 auf weniger als 90 Sekunden im Wesentlichen dadurch, dass der Einschleusvorgang eines Substrats in die Vakuumanlage auf die Einschleuskammer 2 und auf die Pufferkammer 21 aufgeteilt wird und somit in beiden Kammern parallel stattfinden kann, d. h. nachdem ein Substrat von der Einschleuskammer 2 in die Pufferkammer 21 befördert wurde, kann schon wieder ein Substrat in die Einschleuskammer 2 gegeben werden. Um ein Substrat in die Prozesskammer 3 einführen zu können, muss der Druck in der Kammer, die sich vor der Prozesskammer 3 befindet, auf ungefähr 0,05 mbar reduziert werden. Bei der 3-Kammer-Beschichtungsanlage 1 findet dieser Abpumpvorgang bis auf 0,05 mbar ausschließlich in der Einschleuskammer 2 statt.

Dagegen wird bei der 5-Kammer-Beschichtungsanlage 20 in der Einschleuskammer 2 von Atmosphärendruck auf nur ca. 15 mbar abgepumpt und das zu bearbeitende Substrat anschließend in die Pufferkammer 21 überführt. Beim Öffnen des Tors am Ansatz 6 zwischen der Einschleuskammer 2 und der Pufferkammer 21 erfolgt ein Druckausgleich. Der Druck in der Pufferkammer 21, die zuvor zur Prozesskammer 3 hin geöffnet war, in der beispielsweise ein Druck von 3 x 10⁻³ mbar herrscht, ist deutlich kleiner als 0,05 mbar. Die Pufferkammer 21 selbst muss also zunächst gar nicht auf einen niedrigeren Druckwert gepumpt werden. Dadurch, dass die Einschleuskammer 2, in der ein Druck von 15 mbar herrscht, mit der Pufferkammer 21, in der ein Druck von nur 3 x 10⁻³ mbar herrscht, nach Öffnen des Tors am Ansatz 6 verbunden ist, sinkt der Gesamtdruck in den beiden gleich großen Kammern 2 und 21 auf einen Druckmittelwert von ca. 7 mbar ab. Jetzt wird in der Pufferkammer 21, nachdem das Tor bei Ansatz 6 geschlossen wurde, der Druck von ca. 7 mbar mittels Abpumpen auf ca. 0,05 mbar reduziert. Während ein Substrat von der Pufferkammer 21 in die Prozesskammer 3 gegeben wird, kann in der Einschleuskammer 2 bereits wieder der Einschleusvorgang für das nächste Substrat begonnen werden, nachdem die Einschleuskammer 2 geflutet und dann das Tor am Ansatz 5 geöffnet wurde. Durch das Öffnen herrscht wieder Atmosphärendruck in der Einschleuskammer 2, der sodann wieder auf ca. 15 mbar herunter gepumpt wird. Der Druck der Einschleuskammer 2 schwankt somit zwischen Atmosphärendruck und den ca. 15 mbar. Dagegen erfährt die Pufferkammer 21 nur eine Druckänderung von 7 mbar auf 0,05 mbar.

Beim Abpumpen einer Kammer einer Vakuumanlage erfolgt die Druckreduzierung nach einer e-Funktion. Die Druckänderung von ca. 1000 mbar auf ca. 15 mbar erfolgt relativ schnell. Das weitere Abpumpen auf niedrigere Drücke wie z. B. 0,05 mbar nimmt dagegen längere Zeit in Anspruch.

Die verschiedenen Typen von Vakuumpumpen, wie z. B. Drehschieberpumpen, Roots-Pumpen oder Turbomolekularpumpen, haben in verschiedenen Druckbereichen ihr optimales Saugvermögen. Drehschieberpumpen evakuieren von Atmosphärendruck bis auf ca. 0,005 mbar. Um diesen Enddruck zu erreichen, wird aber eine sehr lange Pumpzeit benötigt. Roots-Pumpen sind sehr variabel einsetzbar und haben im Bereich von 1 - 0,1 mbar ihr optimales Saugvermögen. Turbomolekularpumpen werden erst unterhalb von 0,1 mbar zugeschaltet, haben aber erst unterhalb von 10⁻² mbar ein brauchbares Saugvermögen.

Die Pumpen 9 bis 17 bzw. 9 bis 17 und 23, 24 werden entsprechend der Aufgabe, die sie zu erfüllen haben, ausgewählt. Es können die Pumpen für die Einschleuskammer 2 und die Pufferkammer 21 so ausgelegt werden, dass die Pumpzeiten für beide Kammern 2, 21 annähernd gleich sind.

Die Einschleuskammer 2 der 3-Kammeranlage 1 wird mittels Pumpen 9 bis 11 evakuiert, die Drehschieber- und Roots-Pumpen sind. Die Roots-Pumpen erhöhen das Saugvermögen im unteren Druckbereich zum Schaltpunkt von 0,05 mbar, ab dem das Tor am Ansatz 6 zur Prozesskammer 3 hin geöffnet wird. Typische Zykluszeiten sind hier 60 - 90 sec bei ca. 30 - 60 sec Pumpzeit.

Die Einschleuskammer 2 der 5-Kammeranlage 20 wird dagegen mit Pumpen 9 bis 11 evakuiert, die ausschließlich aus Drehschieberpumpen bestehen. Der Pumpstand 23 für die Pufferkammer 21 kann Drehschieber- und Roots-Pumpen enthalten. Beim herkömmlichen 5-Kammer-Betrieb beträgt die Zykluszeit bei ca. 45 sec bei einer Pumpzeit von 15 - 20 sec. Die Differenz zwischen Zykluszeit und Pumpzeit wird unter anderem zum Bewegen der Glasscheiben und Öffnen und Schließen der Tore gebraucht.

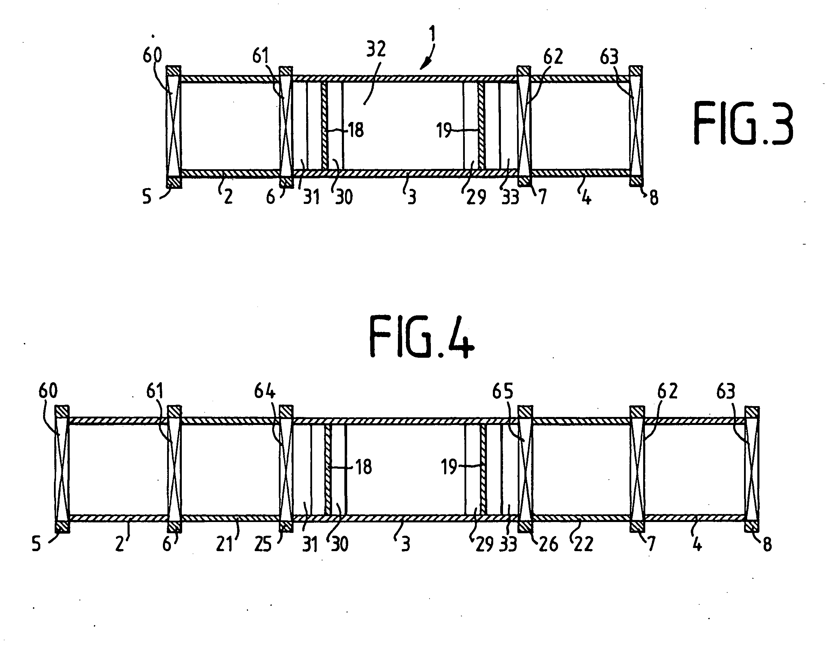

In der Fig. 3 ist die 3-Kammer-Beschichtungsanlage 1 noch einmal in einer Draufsicht dargestellt, während die Fig. 4 die 5-Kammer-Beschichtungsanlage 20 in einer Draufsicht zeigt. Diese 3-Kammer-Beschichtungsanlage stellt kein Ausführungsbeispiel der Erfindung dar.

Man erkennt in der Fig. 3 die Kammern 2, 3, 4 sowie die Ansätze 5, 6, 7, 8 mit den zugeordneten Toren 60, 61, 62, 63. Außerdem erkennt man in der Prozesskammer 3 zwei Spaltenblenden 18, 30 bzw. 19, 29, die Transferkammern 31, 33 definieren. Mit 30, 29 sind dabei Spaltenblenden bezeichnet, die auf den Blechteilen 18, 19 senkrecht stehen.

Die Fig. 4 zeigt die 5-Kammeranlage in einer Draufsicht. Diese 5-Kammeranlage weist zwei zusätzliche Tore 64, 65 auf, die sich zwischen den Kammern 21, 31 bzw. 33, 22 befinden.

Im Standardbetrieb, d. h. wenn keine überlangen Substrate beschichtet werden, laufen bei der Anlage 20 gemäß Fig. 4 folgende Pump-Vorgänge ab: Einschleuskammer 2 ist geflutet, Tor 60 wird geöffnet und ein Substrat wird in die Einschleuskammer 2 befördert. Hierauf wird das Tor 60 wieder geschlossen. Nach Erreichen des Druck-Schaltpunktes von ca. 15 mbar in der Kammer 2 wird das Tor 61 geöffnet und das Substrat in die Kammer 21 befördert. Das Tor 61 wird hierauf wieder geschlossen. Während in der Pufferkammer 21 der Druck auf ca. 0,05 mbar reduziert wird, wird die Einschleuskammer 2 geflutet und danach das Tor 60 geöffnet. Ein neues Substrat wird nun in die Einschleuskammer 2 eingebracht und das Tor 60 schließt wieder. Parallel dazu wird bei Erreichen des Druck-Schaltpunktes von ca. 0,05 mbar in der Pufferkammer 21 das Tor 64 geöffnet und das erste Substrat über die Transferkammer 31 in Prozesskammer 3 bewegt. Bei diesem Betrieb ist im Allgemeinen immer nur eines der Tore 60, 61, 64 geöffnet. Es ist darauf hinzuweisen, dass sich zwischen den Kammern und den Pumpen sowie zwischen den Kammern und der Atmosphären-Umgebung Ventile befinden. Zum Abschalten einer Pumpleistung wird ein Ventil zwischen Kammer und Pumpe geschlossen; dabei laufen aber die Pumpen kontinuierlich weiter. Beim Fluten einer Kammer wird das Ventil vor der Kammer zur Umgebungsluft geöffnet, sodass Luft in die Kammer strömt und der Druck in dieser Kammer auf Atmosphärendruck steigt.

Beim Standardbetrieb der 5-Kammeranlage gemäß Fig. 4 wird somit die Kammer 2 von Atmosphärendruck auf ca. 15 mbar abgepumpt, und beim Öffnen von Tor 61 erfolgt ein Druckausgleich, da der Druck in Kammer 21, die zuvor zur Kammer 3 (ca. 3 x 10⁻³ mbar) hin geöffnet war, deutlich kleiner als 0,05 mbar ist. Dadurch sinkt der Gesamtdruck in beiden gleich großen Kammern 2, 21 auf ca. 7 mbar ab. Kammer 21 wird dann von den ca. 7 mbar auf ca. 0,05 mbar gepumpt. Die Roots-Pumpen in Kammer 21 können ohne Unterbrechung arbeiten, da der Druck in dieser Kammer nur zwischen ca. 7 mbar und kleiner 0,05 mbar variiert.

Beim Standardbetrieb der 5-Kammer-Anlage 20 laufen die Transportsysteme nur bei der Übergabe des Substrats von der Einschleuskammer 2 in die Pufferkammer 21 synchron. Während der übrigen Bewegungsphasen können beide Transportsysteme unabhängig voneinander die jeweiligen Substrate transportieren.

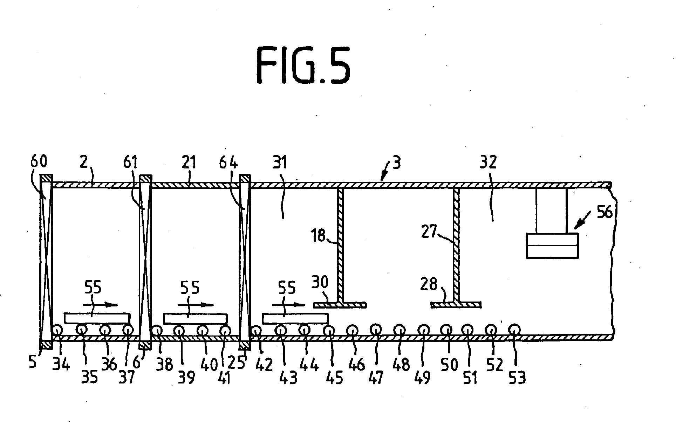

In der Fig. 5 ist die linke Hälfte einer der Anlage 20 gemäß Fig. 4 ähnlichen Anlage noch einmal im Schnitt dargestellt. Von der Anlage gemäß Fig. 4 unterscheidet sich die Anlage dadurch, dass sie außer der Spaltenblende 30 noch eine weitere Spaltenblende 28 besitzt. Man erkennt hierbei Rollen oder Walzen 34 bis 37 in der Einschleuskammer 2, Rollen oder Walzen 38 bis 41 in der Pufferkammer 21 und Rollen oder Walzen 42 bis 53 in der Prozesskammer 3. Auf diesen Rollen oder Walzen befindet sich ein Substrat 55, das von links nach rechts bewegt wird.

Die Spaltenblenden 30, 28 sind an Blechen 18, 27 aufgehängt und lassen auf ihrer Unterseite einen Spalt frei, der so groß ist, dass das Substrat 55 unter der Spaltblende vorbeigeführt werden kann. In der eigentlichen Prozesskammer 32 befindet sich eine Sputterkathode 56. Mit Teilchen, die von der Kathode abgestäubt werden, wird das Substrat 55 beschichtet.

Die Spaltblenden 30, 28 gehen über die ganze Tiefe der Prozesskammer 3. Dies gilt auch für die Aufhängungen 18, 27 dieser Spaltblenden.

Um die Gastrennung zwischen den Kammern zu verbessern, kann das Transportsystem noch zusätzlich mit einem in der Fig. 5 nicht dargestellten Blech abgedeckt werden, aus dem nur der obere Bereich der Transportrollen herausschaut.

Die Substrattransportvorrichtung weist somit viele Rollen oder Walzen 34 bis 53 auf, die mit gleicher Drehzahl drehend die Substrate befördern. Die Transportvorrichtung weist an den Stellen, an denen die Tore 61, 64, 65, 62 vorgesehen sind, Unterbrechungen bzw. größere Abstände zwischen den Rollen oder Walzen auf. Die Abschnitte der Transportvorrichtung in den Kammern 2, 21, 22 und 4 arbeiten intermittierend, der Abschnitt in Kammer 3 arbeitet kontinuierlich.

Im Standardbetrieb erfolgt der Substrattransport in der 5-Kammeranlage unter Bezugnahme auf die Fig. 4 und 5 wie folgt: Die Transportvorrichtung in Kammer 2 wird eingeschaltet, um das Substrat 55 einzuschleusen. Hat das Substrat 55 seine vorgesehene Position in der Kammer 2 erreicht, wird der Transport abgeschaltet. Zur Übergabe des Substrates 55 aus Kammer 2 in Kammer 21 sind beide Transportvorrichtungen mit den Walzen 34 bis 37 bzw. 38 bis 41 gleichzeitig in Betrieb und werden erst dann abgeschaltet, wenn das Substrat 55 seine Endposition in Kammer 21 erreicht hat. Um das Substrat 55 in Kammer 3 zu befördern, wird die Transporteinrichtung 38 bis 41 in Kammer 21 eingeschaltet, die Transportvorrichtung 42 bis 53 in Kammer 3 läuft ohnehin ohne Unterbrechung. Zur Übergabe von der Kammer 3 in die Kammer 22 (Fig. 2) wird die dort befindliche Transportvorrichtung gleichzeitig mit dem Öffnen des Tors 65 eingeschaltet. Der weitere Ausschleusvorgang erfolgt analog zum Einschleusvorgang in umgekehrter Reihenfolge.

Die Einschleuskammer 2 wird mit einem Pumpstand evakuiert, der nur aus Drehschieberpumpen besteht, der Pumpstand für Kammer 21 umfasst dagegen Drehschieber- und Roots-Pumpen. Beim Fluten einer Kammer wird nicht die Pumpe abgeschaltet, sondern ein Ventil zwischen der Kammer und der Pumpe geschlossen.

Bisher wurden die an sich bekannten Funktionen einer 3-Kammeranlage 1 und einer 5-Kammeranlage 20 beschrieben.

Nachfolgend wird unter Bezugnahme auf die Fig. 4 und 5 beschrieben, wie erfindungsgemäß mit Hilfe einer 5-Kammeranlage auch größere Substrate beschichtet werden können.

Für beide Anlagen 1 bzw. 20 gilt, dass das maximal zulässige Substratmaß abhängig von den Dimensionen der jeweiligen Kammern ist. Substrate, die größer als die Kammern 2 bzw. 21 oder 22 bzw. 4 sind, können nicht beschichtet werden. Weiterhin gilt, dass die Kammern als Module mit gleichen Abmessungen ausgebildet sind.

Wie man aus der Fig. 4 ersieht, könnten größere Substrate behandelt werden, wenn die Tore 61, 62 offen wären. In diesem Fall würden die Kammern 2 und 21 sowie 4 und 22 jeweils gemeinsam einen größeren Raum bilden, in dem dann auch ein größeres Substrat untergebracht werden könnte.

Für die Schleusenkammern 2, 21, 22, 4 werden die gleichen Module in gleicher Größe verwendet, unabhängig davon, ob es sich um eine 3-Kammer-Anlage 1 oder eine 5-Kammer-Anlage 20 handelt. Da mit beiden Anlagen 1 bzw. 20 normalerweise die gleichen Substrate mit der gleichen maximalen Größe beschichtet werden, müssen die Kammern auch dieselben Abmessungen haben.

Geht man also davon aus, dass die Einschleus-, Puffer- und Ausschleuskammer alle gleich groß sind, weil sie als Module ausgebildet sind, können bei geöffneten Toren 61, 62 Substrate mit doppelt so großen Längen bearbeitet werden. Die Bearbeitung, insbesondere Beschichtung von teilweise geforderten Sondermaßen von beispielsweise mehr als 6 m Länge und 3,21 m Breite wären somit auch in Beschichtungsanlagen mit Standard-Kammergrößen möglich.

Anhand dieser Figuren 3 und 4 wird der erfindungsgemäße Umschaltvorgang von der 5-Kammer-Beschichtung auf die 3-Kammer-Beschichtung erläutert.

Um von einem 5-Kammer-Betrieb auf einen 3-Kammer-Betrieb umzuschalten, genügt es nicht, lediglich die Tore 61 und 62 zwischen der Einschleuskammer 2 und der Pufferkammer 21 bzw. der Ausschleuskammer 4 und der Pufferkammer 22 zu öffnen. Vielmehr müssen die Pumpsequenz und die Antriebssteuerung der neuen Situation angepasst werden. Es sind somit erhebliche Änderungen im Einschleusverfahren nötig. Das Einschleusen eines Substrats bei der 3-Kammer-Beschichtungsanlage 1 erfolgt, wie bereits erwähnt, durch Abpumpen der Einschleuskammer 2 mittels der Pumpen 9 bis 11 auf einen Druck von ungefähr 0,05 mbar. Um die Einschleuskammer 2 von Atmosphärendruck auf Umschleusdruck zu evakuieren, benötigt man recht lange Pumpzeiten. Da das Tor 61 zur Prozesskammer 3 hin geöffnet wird, wenn ein Substrat in die Prozesskammer überführt wird, können Gase mit zu hohem Druck in die Prozesskammer 3 gelangen, die nur einen Druck von 3 x 10⁻³ mbar haben darf. Um das zu verhindern, werden im Eintrittsbereich der Prozesskammer 3 eine erhöhte Zahl von Pumpen 12 angeordnet, von denen in der Fig. 1 nur eine Pumpe 12 dargestellt ist. Dieser Eintrittsbereich ist mittels einer Spaltenblende 18, 30 vom eigentlichen Prozessbereich 32 getrennt. Dieser Einrittsbereich wird auch als Transferkammer 31 bezeichnet, obwohl er nur durch die Spaltenblende 18, 30, aber nicht durch Tore von der Prozesskammer 3 abgetrennt ist. Die Prozesskammer 3 besteht somit aus einem Transferbereich 31, einem Prozessbereich 32 und einem weiteren Transferbereich 33 vor der Ausschleuskammer 4, wobei zwischen dem Transferbereich 33 und dem Prozessbereich eine weitere Spaltenblende 19, 29 vorgesehen ist.

Der Abschnitt 31 der Prozesskammer, der über mehrere Turbo-Pumpen 12 evakuiert wird, wird als "Transferabschnitt" bezeichnet. Die eigentliche Prozesskammer 32 ist aus vielen einzelnen, gleich großen Segmenten zusammengesetzt, wobei je nach Anforderung so viele Segmente aneinander gehängt werden, dass darin die jeweiligen Aufgaben durchgeführt werden können. In der Einschleuskammer 2 herrscht bei einer 3-Kammeranlage 1 ein Druck von 0,05 mbar, sodass beim Öffnen des Tors 61 Gas in die Prozesskammer 32 überströmt, da hier der Druck bei ca. 3 x 10⁻³ mbar liegt. Dieser Druckstoß wird im "Transferabschnitt" der Prozesskammer 3 durch das hohe Saugvermögen mehrerer Turbo-Pumpen abgefangen.

Im Sonderbetrieb für überlange Substrate, d. h. wenn die 5-Kammeranlage 20 als 3-Kammeranlage 1 betrieben wird, laufen in der 5-Kammeranlage gemäß Fig. 4 folgende Vorgänge ab: Die Kammern 2 und 21 sind geflutet. Das Tor 60 wird geöffnet. Das Tor 61 bleibt bei diesem Betriebszustand immer offen, da sonst das Substrat zerstört wird. Ein Substrat wird in die Kammern 2 und 21 befördert, dann wird das Tor 60 wieder geschlossen. Nach Erreichen des Druck-Schaltpunktes von ca. 0,05 mbar wird das Tor 64 geöffnet, das Substrat in die Prozesskammer 3 befördert und das Tor 64 wird wieder geschlossen. Nach Fluten der Kammern 2 und 21 wird das Tor 60 wieder geöffnet, um erneut ein Substrat einzuschleusen.

Der jeweilige Ausschleusvorgang erfolgt analog, aber in umgekehrter Abfolge d. h. erst ist das Substrat in der Ausschleuskammer 22, dann erfolgt Fluten, dann das Öffnen des Tores 63 zur Atmosphäre hin.

Es genügt also nicht, bei der 5-Kammer-Anlage 20 die Tore 61, 62 zwischen den beiden Kammern 2, 21 bzw. 4, 22 zu öffnen, um Substrate - vorzugsweise Glasscheiben - mit Überlänge bearbeiten zu können; es müssen darüber hinaus auch die Pumpprogramme für die beiden Kammern 2, 21 bzw. 22, 4 angepasst werden, sodass nur beide Kammern 2, 21 bzw. 22, 4 von Atmosphärendruck auf die ca. 0,05 mbar abgepumpt werden. Das verlängert zwar die Einschleuszeit und damit die gesamte Zykluszeit der Anlage, aber so können wenigstens Substrate mit Überlänge bearbeitet werden, ohne dass eine größere Anlage gebaut werden muss.

Beim Sonderbetrieb für überlange Substrate erfolgt das Pumpen in der 5-Kammeranlage im Einzelnen in nachfolgenden Schritten: Die Kammern 2 und 21 werden beide zusammen von Atmosphärendruck auf ca. 0,05 mbar abgepumpt. Dazu muss beim Pumpprogramm für die Kammer 2 der Druckschaltpunkt von 15 mbar auf 7 mbar gesenkt werden. Der Pumpsatz für die Kammer 2 pumpt dann nur von Atmosphärendruck auf 7 mbar, dann wird das Ventil zwischen Pumpsatz und Kammer 2 geschlossen, gleichzeitig aber das Ventil zwischen dem zweiten Pumpsatz und der Kammer 21 geöffnet, welches bisher geschlossen war. Der Grund dafür ist, dass der Pumpsatz der Kammer 2 aus Drehschieberpumpen besteht, die von Atmosphärendruck herunterpumpen können. Der Pumpsatz der Kammer 21 enthält außer Drehschieberpumpen auch Roots-Pumpen, die erst ab ca. 7 mbar zugeschaltet werden dürfen. Um die vergrößerte Einschleuskammer 2 + 21 auf die ca. 0,05 mbar abpumpen zu können, werden also beide Pumpsätze nacheinander verwendet und arbeiten nicht parallel wie im Standardbetrieb.

Das Fluten und Abpumpen der Kammern 22 und 4 erfolgt analog.

Weiterhin muss das Transportsystem für die Substrate an eine andere Einschleussequenz angepasst werden.

Wird die 5-Kammer-Anlage 20 für die Beschichtung von überlangen Substraten verwendet, müssen die Transportsysteme beim Einschleusvorgang synchron wie ein einziges System arbeiten, da sonst Kratzer an den Substraten erzeugt würden. Wenn das Substrat von einem Abschnitt des Transportsystems auf einen anderen Abschnitt geschoben wird, der nicht eingeschaltet wird, schleifen entweder die sich drehenden Rollen an der Substratunterseite oder die Scheibe wird über die sich nicht drehenden Rollen geschoben, wobei in beiden Fällen Schleifspuren erzeugt werden.

Beim Sonderbetrieb für überlange Substrate 55 erfolgt der Transport in der 5-Kammeranlage gemäß Fig. 4, 5 wie folgt: Während im Standardbetrieb die Transportvorrichtungen 34 bis 37 bzw. 38 bis 41 in den Kammern 2 und 21 je nach Bedarf synchron oder unabhängig voneinander arbeiten, werden beide Vorrichtungen nun so behandelt, als ob sie eine einzige zusammenhängende Transportvorrichtung wären. Dabei muss das Erreichen der Endposition des Substrates 55 in Kammer 2 ignoriert werden, d. h. es muss bis zur Endposition in Kammer 21 durchfahren. Es gibt hier keinen Betriebszustand, bei dem die einzelnen Abschnitte der Transportvorrichtung in den Kammern 2 und 21 unabhängig voneinander arbeiten. Die weitere Substratbeförderung erfolgt analog.

Die Steuerung der Pumpen, Transportrollen, Tore etc. erfolgt vorzugsweise mittels einer speicherprogrammierbaren Steuerung (SPS), die in Form von Steuerungscomputern im Handel erhältlich sind.

Mit einer solchen Steuerung können auch größte Industrieanlagen mit flexiblen Programmen (SPS-Programm-Sequenz) gesteuert werden. Sämtliche zur Anlage gehörenden Messsysteme, Endschalter, Sensoren, Motoren, Stellgeräte etc. werden mit den Ein- und Ausgängen des Steuerungscomputers verbunden. Die eigentliche Anlagensteuerung wird von dem Programm übernommen, das diese Ein- und Ausgänge logisch miteinander verknüpft und die nötigen Aktionen in die zeitlich richtige Abfolge setzt. Soll eine vorstehend beschriebene Anlage in verschiedenen Betriebszuständen steuerbar sein, so sind keine wesentlichen Hardware-Änderungen nötig. Soweit flexibel programmierbare Drucksensoren anstelle von Druckmessdosen mit festen Schaltpunkten verwendet werden, müssen nur die notwendigen neuen Verknüpfungen unter Abfrage der geänderten Druckschaltpunkte in alternativen Programmsequenzen hinterlegt und getrennt anwählbar sein.

Für das Einschleusen eines Substrats ist keine exakte Druckmessung erforderlich, es reicht das Signal eines Sensors aus, das besagt, dass der gewünschte Druck (z. B. 15 mbar) jetzt erreicht ist. Früher wurden hierfür Duckmessdosen eingesetzt, die einen festen Druckschaltpunkt aufwiesen. Wurden alternative Druckschaltpunkte benötigt, mussten weitere Druckmessdosen eingebaut werden, die auf diese Druckpunkte eingestellt waren. Heute reicht ein elektronisches Druckmessgerät, dessen Messwert im SPS-Programm nur daraufhin abgefragt wird, ob der an der jeweiligen Programmstelle gewünschte Druck erreicht wurde.

Der Erfindungsgedanke kann im Prinzip auch auf 2n + 1-Kammeranlagen Anwendung finden, wobei n eine ganze Zahl und größer oder gleich 2, vorzugsweise gleich 2 ist. In der Praxis realisierbar wäre noch eine 7-Kammeranlage. Bei Anlagen mit noch mehr Kammern stünde der Kostenaufwand nicht mehr in einem vernünftigen Verhältnis zur möglichen Verkürzung der Zykluszeit und damit zur Erhöhung der Produktivität.

## Patentansprüche

1. Verfahren für den Betrieb einer Inline-Beschichtungsanlage, mit einer Einschleuskammer (2), einer daran anschließenden Pufferkammer (21), einer hieran anschließenden Prozesskammer (3), einer hieran anschließenden weiteren Pufferkammer (22) und einer hieran anschließenden Ausschleuskammer (4), wobei zwischen den Kammern Tore (61, 64, 65, 62) vorgesehen sind, die geöffnet und geschlossen werden können, und wobei die Einschleuskammer (2), die Pufferkammer (21, 22) und die Ausschleuskammer (4) als gleichartige Module und für die Aufnahme von Substraten bis zu einer vorgegebenen Maximalgröße ausgebildet sind, **dadurch gekennzeichnet, dass** für die Beschichtung von Substraten (55), die größer als die Module sind, das Tor (61) zwischen der Einschleuskammer (2) und der Pufferkammer (21) sowie das Tor (62) zwischen der Pufferkammer (22) und der Ausschleuskammer (4) geöffnet werden und die Druckverhältnisse der Pufferkammern (21, 22) und der Einschleus- (2) bzw. Ausschleuskammer (4) aneinander angepasst werden.

2. Verfahren nach Anspruch 1, **dadurch gekennzeichnet, dass** die Kammern (2, 21, 3, 22, 4) mit jeweils eigenen Transportvorrichtungen (34 bis 37; 38 bis 41; 42 bis 53) für Substrate (55) ausgestattet sind und die Transportgeschwindigkeiten dieser Transportvorrichtungen (34 bis 37; 38 bis 41; 42 bis 53) aufeinander abgestimmt werden.

3. Verfahren nach Anspruch 1, **dadurch gekennzeichnet, dass** die Prozesskammer (3) wenigstens zwei Spaltblenden (30, 29) aufweist, von denen die eine Spaltblende (30) eine linke Begrenzung der eigentlichen Prozesskammer (33) und die andere Spaltblende (29) eine rechte Begrenzung der eigentlichen Prozesskammer (33) bildet.

4. Verfahren nach Anspruch 1, **gekennzeichnet durch** folgende Schritte:
- das Tor (61) am Eingang zur ersten Pufferkammer (21) und das Tor (62) zwischen der zweiten Pufferkammer (22) und der Ausschleuskammer (4) sind geöffnet
- das Tor (60) am Eingang der Einschleuskammer (2) wird geöffnet
- ein Substrat von einer die Länge der Einschleuskammer (2) oder der Pufferkammer (21) übersteigenden Länge wird in die Einschleuskammer (2) und die Pufferkammer (21) befördert
- das Tor (60) am Eingang der Einschleuskammer (2) wird geschlossen
- der **durch** die Einschleuskammer (2) und die Pufferkammer (21) gebildete Raum wird bei geschlossenem Tor (64) am Eingang der Prozesskammer (3) bis zu einem vorgegebenen Druck evakuiert
- bei Erreichen des vorgegebenen Drucks wird das Tor (64) am Eingang der Prozesskammer (3) geöffnet
- das Substrat (55) wird in die Prozesskammer (3) befördert und das Tor (64) am Eingang der Prozesskammer (3) wird wieder geschlossen
- das Substrat (55) wird in der Prozesskammer (3) bearbeitet
- das Tor (65) am Ausgang der Prozesskammer (3) wird geöffnet
- das bearbeitete Substrat (55) wird in den aus der Pufferkammer (22) und der Ausschleuskammer (4) gebildeten Raum gebracht
- das Tor (65) am Ausgang der Prozesskammer (3) wird geschlossen
- das Tor (63) am Ausgang der Ausschleuskammer (4) wird geöffnet
- das bearbeitete Substrat (55) wird nach draußen verbracht
- das Tor (63) am Ausgang der Ausschleuskammer wird geschlossen.

5. Verfahren nach Anspruch 4, **dadurch gekennzeichnet, dass** nach dem Einschleusen des Substrats in den aus der Einschleuskammer (2) und Pufferkammer (21) gebildeten Raum und nach Schließen des Tors (60) zunächst die der Einschleuskammer (2) zugeordneten Pumpen (9 bis 11) von Atmosphärendruck auf einen ersten vorgegebenen Druck evakuieren und dass im Anschluss hieran die der Pufferkammer (21) zugeordneten Pumpen (23) auf einen Druck evakuieren, der etwa dem Druck der Prozesskammer (3) entspricht.

6. Verfahren nach Anspruch 5, **dadurch gekennzeichnet, dass** der Druck in dem aus Einschleuskammer (2) und Pufferkammer (21) gebildeten Raum von Atmosphärendruck zunächst auf etwa 7 mbar und anschließend der Druck in dem gleichen Raum auf etwa 0,05 mbar gesenkt wird.

7. Verfahren nach Anspruch 1, **dadurch gekennzeichnet, dass** die Transportvorrichtung (34 bis 37) der Einschleuskammer (2) und die Transportvorrichtung (38 bis 41) der anschließenden Pufferkammer (21) synchron betrieben werden.

8. Verfahren nach Anspruch 7, **dadurch gekennzeichnet, dass** die Transportvorrichtung (42 bis 53) der Prozesskammer (3) mit der gleichen Geschwindigkeit betrieben wird wie die Transportvorrichtungen (34 bis 37; 38 bis 41) der Einschleuskammer (2) und der Pufferkammer (21).

9. Verfahren nach Anspruch 1, **dadurch gekennzeichnet, dass** in allen Kammern (2, 21, 3, 22, 4) Druckmessgeräte vorgesehen sind, deren Druck von einer Steuerung abgefragt wird, und dass diese Steuerung bei Erreichen vorgegebener Drücke eine Schalthandlung ausführt.

10. Verfahren nach Anspruch 9, **dadurch gekennzeichnet, dass** die Schalthandlung das Öffnen oder Schließen von Toren oder das Öffnen oder Schließen von Ventilen ist, die zwischen Kammer und Pumpe angeordnet sind.

## Claims

1. Method for the operation of an in-line coating installation with an inward transfer chamber (2), an adjoining buffer chamber (21), a process chamber (3) adjoining thereon, a further buffer chamber (22) adjoining it and an outward transfer chamber (4) adjoining it, with gates (61, 64, 65, 62) provided between the chambers, which can be opened and closed, and where the inward transfer chamber (2), the buffer chamber (21, 22) and the outward transfer chamber (4) are developed as identical modules and for receiving substrates up to a specified maximum size, **characterized in that** for the coating of substrates (55), which are greater than the modules, the gate (61) between the inward transfer chamber (2) and the buffer chamber (21) as well as the gate (62) between the buffer chamber (22) and the outward transfer chamber (4) are opened and the pressure conditions of the buffer chambers (21, 22) and of the inward transfer (2) or outward transfer chamber (4) are adapted to one another.

2. Method as claimed in claim 1, **characterized in that** the chambers (2, 21, 3, 22, 4) are equipped with their own transport arrangements (34 to 37; 38 to 41; 42 to 53) for substrates (55) and the transport rates of these transport arrangements (34 to 37; 38 to 41; 42 to 53) are matched to one another.

3. Method as claimed in claim 1, **characterized in that** the process chamber (3) comprises at least two slit diaphragms (30, 29), of which the one slit diaphragm (30) forms a left boundary of the process chamber (33) proper and the other slit diaphragm (29) a right boundary of the process chamber (33) proper.

4. Method as claimed in claim 1, **characterized by** the following steps:
- the gate (61) at the entrance to the first buffer chamber (21) and the gate (62) between the second buffer chamber (22) and the outward transfer chamber (4) are opened,
- the gate (60) at the entrance of the inward transfer chamber (2) is opened,
- a substrate of a length exceeding the length of the inward transfer chamber (2) or of the buffer chamber (21) is transported into the inward transfer chamber (2) and the buffer chamber (21),
- the gate (60) at the entrance of the inward transfer chamber (2) is closed,
- the space formed by the inward transfer chamber (2) and, with the gate (64) at the entrance to the process chamber (3) closed, the buffer chamber (21) is evacuated to a specified pressure,
- upon reaching a specified pressure, the gate (64) at the entrance of the process chamber (3) is opened,
- the substrate (55) is transported into the process chamber (3) and the gate (64) at the entrance of the process chamber (3) is closed again,
- the substrate (55) is worked in the process chamber (3),
- the gate (65) at the exit of the process chamber (3) is opened,
- the worked substrate (55) is moved into the space formed of the buffer chamber (22) and the outward transfer chamber (4),
- the gate (65) at the exit of the process chamber (3) is closed,
- the gate (63) at the exit of the outward transfer chamber (4) is opened,
- the worked substrate (55) is moved to the outside,
- the gate (63) at the exit of the outward transfer chamber is closed.

5. Method as claimed in claim 4, **characterized in that** after the inward transfer of the substrate into the space formed of the inward transfer chamber (2) and buffer chamber (21) and, after the gate (60) is closed, first the pumps (9 to 11) associated with the inward transfer chamber (2) carry out an evacuation from atmospheric pressure to a first specified pressure, and that subsequently the pumps (23) associated with the buffer chamber (21) carry out an evacuation to a pressure corresponding approximately to the pressure of the process chamber (3).

6. Method as claimed in claim 5, **characterized in that** the pressure in the space formed of the inward transfer chamber (2) and buffer chamber (21) is lowered from atmospheric pressure first to approximately 7 mbar and, subsequently, the pressure in the same space is decreased to approximately 0.05 mbar.

7. Method as claimed in claim 1, **characterized in that** the transport arrangement (34 to 37) of the inward transfer chamber (2) and the transport arrangement (38 to 41) of the adjoining buffer chamber (21) are operated synchronously.

8. Method as claimed in claim 7, **characterized in that** the transport arrangement (42 to 53) of the process chamber (3) is operated at the same rate as the transport arrangements (34 to 37; 38 to 41) of the inward transfer chamber (2) and the buffer chamber (21).

9. Method as claimed in claim 1, **characterized in that** in all chambers (2, 21, 3, 22, 4) pressure meters are provided, whose pressure is queried by a control, and that this control carries out a switching action when specified pressures are reached.

10. Method as claimed in claim 9, **characterized in that** the switching action is the opening or closing of gates or the opening or closing of valves disposed between chamber and pump.

## Revendications

1. Procédé pour l'usage d'un dispositif de revêtement en continu, comportant une chambre de chargement (2), une chambre tampon (21) s'y raccordant, une chambre de processus (3) se raccordant à cette dernière, une autre chambre tampon (22) se raccordant à cette dernière et une chambre de déchargement (4) se raccordant à cette dernière, moyennant quoi entre les chambres, des portes (61, 64, 65, 62) sont prévues, lesquelles peuvent être ouvertes et fermées et moyennant quoi la chambre de chargement (2), la chambre tampon (21, 22) et la chambre de déchargement (4) sont réalisées comme des modules de type similaire et conçues afin de recevoir des substrats allant jusqu'à une taille maximale prescrite, **caractérisé en ce que** en vue du revêtement de substrats (55), qui sont plus grands que les modules, la porte (61) entre la chambre de chargement (2) et la chambre tampon (21) ainsi que la porte (62) entre la chambre tampon (22) et la chambre de déchargement (4) sont ouvertes et les rapports de pression des chambres tampons (21, 22) et de la chambre de chargement (2), respectivement de la chambre de déchargement (4) sont adaptés les uns aux autres.

2. Procédé selon la revendication 1, **caractérisé en ce que** les chambres (2, 21, 3, 22, 4) sont équipées de dispositifs de transport (34 à 37; 38 à 41; 42 à 53) qui leur sont respectivement propres pour les substrats (55) et les vitesses de transport de ces dispositifs de transport (34 à 37; 38 à 41; 42 à 53) peuvent être ajustées les unes aux autres.

3. Procédé selon la revendication 1, **caractérisé en ce que** la chambre de processus (3) présente au moins deux panneaux de division (30, 29), dont un panneau de division (30) forme une délimitation gauche de la chambre de processus (33) proprement dite et l'autre panneau de division (29) forme une délimitation droite de la chambre de processus (33) proprement dite.

4. Procédé selon la revendication 1, **caractérisé par** les étapes suivantes :
- la porte (61) à l'entrée de la première chambre tampon (21) et la porte (62) entre la deuxième chambre tampon (22) et la chambre de déchargement (4) sont ouvertes,
- la porte (60) à l'entrée de la chambre de chargement (2) est ouverte,
- un substrat d'une longueur dépassant la longueur de la chambre de chargement (2) ou de la chambre tampon (21) est transporté dans la chambre de chargement (2) et la chambre tampon (21),
- la porte (60) à l'entrée de la chambre de chargement (2) est fermée,
- l'espace formé par la chambre de chargement (2) et la chambre tampon (21) est, lorsque la porte (64) est fermée à l'entrée de la chambre de processus (3), mis au vide jusqu'à une pression prescrite,
- lorsque la pression prescrite est atteinte, la porte (64) à l'entrée de la chambre de processus (3) est ouverte,
- le substrat (55) est transporté dans la chambre de processus (3) et la porte (64) à l'entrée de la chambre de processus (3) est à nouveau fermée,
- le substrat (55) est traité dans la chambre de processus (3),
- la porte (65) à l'entrée de la chambre de processus (3) est ouverte,
- le substrat (55) à traiter est amené dans l'espace formé par la chambre tampon (22) et la chambre de déchargement (4),
- la porte (65) à la sortie de la chambre de processus (3) est fermée,
- la porte (63) à la sortie de la chambre de déchargement (4) est ouverte,
- le substrat (55) à traiter est amené vers l'extérieur,
- la porte (63) à la sortie de la chambre de déchargement est fermée.

5. Procédé selon la revendication 4, **caractérisé en ce que** après le chargement du substrat dans l'espace formé par la chambre de chargement (2) et la chambre tampon (21) et après la fermeture de la porte (60), tout d'abord les pompes (9 à 11) affectées à la chambre de chargement (2) sont mises au vide de la pression atmosphérique jusqu'à une première pression prescrite et, en liaison avec ceci, les pompes (23) affectées à la chambre tampon (21) sont mises au vide à une pression, qui correspond approximativement à la pression de la chambre de processus (3).

6. Procédé selon la revendication 5, **caractérisé en ce que** la pression dans l'espace formé par la chambre de chargement (2) et la chambre tampon (21) est d'abord abaissée de la pression atmosphérique jusqu'à environ 7 mbar et ensuite la pression dans le même espace est abaissée à environ 0,05 mbar.

7. Procédé selon la revendication 1, **caractérisé en ce que** le dispositif de transport (34 à 37) de la chambre de chargement (2) et le dispositif de transport (38 à 41) de la chambre tampon (21) s'y raccordant sont exploités de manière synchrone.

8. Procédé selon la revendication 7, **caractérisé en ce que** le dispositif de transport (42 à 53) de la chambre de processus (3) est exploité à la même vitesse que les dispositifs de transport (34 à 37; 38 à 41) de la chambre de chargement (2) et de la chambre tampon (21).

9. Procédé selon la revendication 1, **caractérisé en ce que** dans toutes les chambres (2, 21, 3, 22, 4), des appareils de mesure de la pression sont prévus, dont la pression est consultée par une unité de commande et **en ce que** cette unité de commande exécute une manoeuvre de commutation lorsque des pressions prescrites sont atteintes.

10. Procédé selon la revendication 9, **caractérisé en ce que** la manoeuvre de commutation est l'ouverture ou la fermeture de portes ou l'ouverture ou la fermeture de soupapes, qui sont disposées entre la chambre et la pompe.
